# EUROPEAN PATENT SPECIFICATION

(11) **EP 3 290 210 B1**
(45) Date of publication and mention of the grant of the patent: **25.09.2019**
(21) Application number: 17179903.4
(22) Date of filing: 06.07.2017
(51) Int. Cl.: B41J 2/14, B41J 2/16, F04B 43/00, F04B 43/04, F04B 45/04, F04B 45/047, F04B 53/22, F04D 3/00

(54) **MANUFACTURING METHOD OF FLUID CONTROL DEVICE**
HERSTELLUNGSVERFAHREN EINER FLUIDSTEUERUNGSVORRICHTUNG
PROCÉDÉ DE FABRICATION D'UN DISPOSITIF DE RÉGULATION DE FLUIDE

(30) Priority: 05.09.2016 TW 105128591
(43) Date of publication of application: 07.03.2018
(73) Proprietor: Microjet Technology Co., Ltd, Hsinchu (TW)
(72) Inventor: HAN, Yung-Lung, Science-Based Industrial Park, Hsinchu (TW); HUANG, Chi-Feng, Science-based Industrial Park, Hsinchu (TW)
(74) Representative: 2K Patentanwälte Blasberg Kewitz & Reichel

(56) References cited:
- JP-A- H10 213 073
- US-A1- 2015 071 797
- US-A1- 2016 010 636

## Description

### FIELD OF THE INVENTION

The present invention relates to a manufacturing method of a fluid control device, and more particularly to a manufacturing method of a fluid control device with a deformable base.

### BACKGROUND OF THE INVENTION

With the advancement of science and technology, fluid control devices are widely used in many sectors such as pharmaceutical industries, computer techniques, printing industries or energy industries. Moreover, the fluid control devices are developed toward elaboration and miniaturization. The fluid control devices are important components that are used in for example micro pumps, micro atomizers, printheads or industrial printers for transporting fluid. Therefore, it is important to provide an improved structure of the fluid control device.

US 2015/071797A1 discloses a piezoelectric blower including a housing, top plate, side plate, vibrating plate, piezoelectric element, and cap. The top plate, side plate, and vibrating plate define a blower chamber. The top plate includes a vent hole. The vibrating plate and piezoelectric element constitutes a piezoelectric actuator. The cap includes a wall portion facing the piezoelectric actuator and has a disc-shaped suction port. Here, a central axis of the suction port extending along a thickness direction of the wall portion and a central axis of the piezoelectric element extending along the thickness direction of the wall portion do not coincide with each other. An air channel is provided among the housing, the cap, and a joined structure of the top plate, side plate, and piezoelectric actuator.

JP H 10 213 073 A discloses a piezoelectric pump which provides improved durability without reducing secular pump performance by forming at least a part of a casing of a piezoelectric pump out of a resin material having specified flexural rigidity and a temperature change ratio, and specifying a piezoelectric strain constant in the horizontal direction having a specified permittivity in a piezoelectric body. When AC power is applied between electric poles of a piezoelectric body so as to vibrate the piezoelectric body, the inside of a pump chamber becomes negative pressure, and thereby, a carries fluid is absorbed through a suction side check valve. When the inside of a pump chamber becomes positive pressure, a delivery side check valve is opened so as to deliver the carried fluid. A pump actuator unit for composing a casing of a piezoelectric pump, a pump sucking and delivering unit 1, and a pump valve seat unit are formed of a thermoplastic resin and the like. In a range in which a flexural rigidity ratio is set to 1GPA or more at a normal temperature and temperature change is set to 20 deg.C to 50 deg.C, it is formed of a resin having the change ratio of the flexural rigidity ratio of 15% and less.

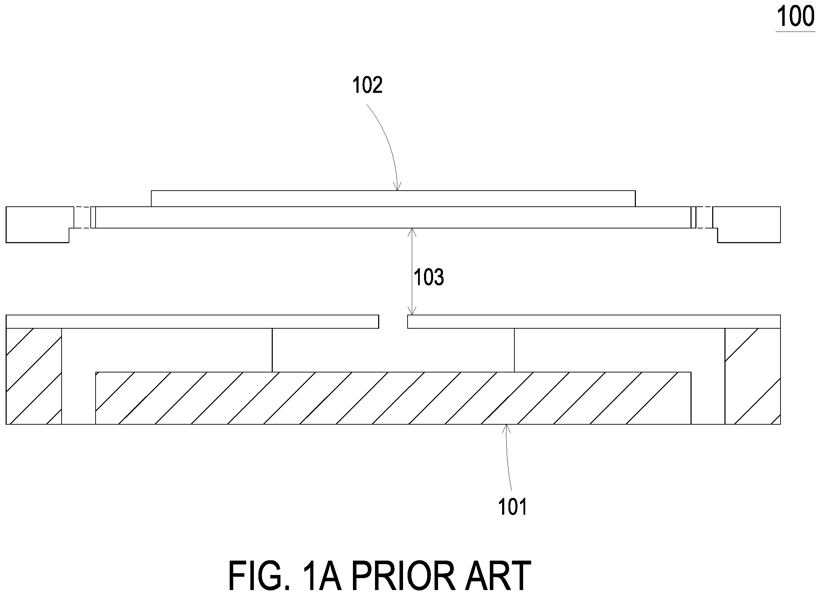

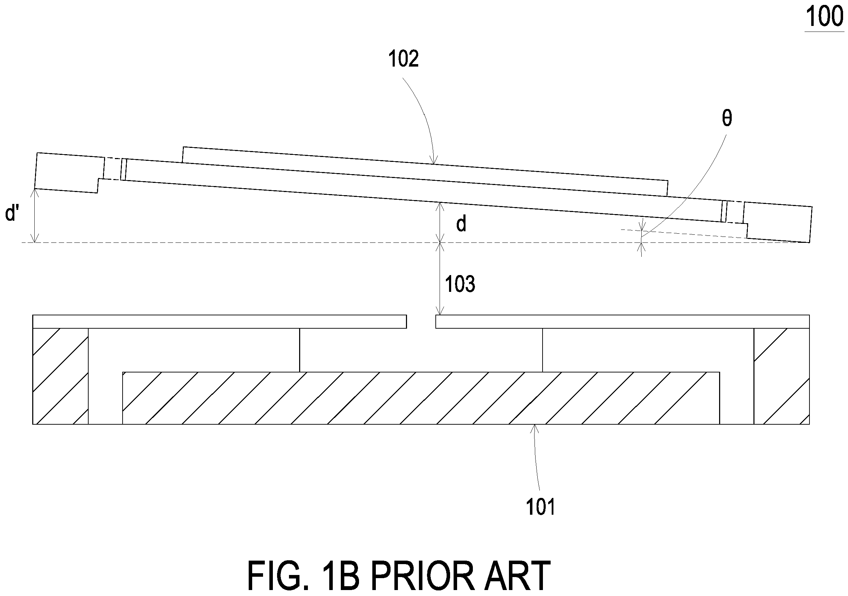

FIG. 1A is a schematic cross-sectional view illustrating a portion of a conventional fluid control device. FIG. 1B is a schematic cross-sectional view illustrating an assembling shift condition of the conventional fluid control device. The main components of the conventional fluid control device 100 comprise a substrate 101 and a piezoelectric actuator 102. The substrate 101 and the piezoelectric actuator 102 are stacked on each other, assembled by any well known assembling means such as adhesive, and separated from each other by a gap 103. In an ideal situation, the gap 103 is maintained at a specified depth. More particularly, the gap 103 specifies the interval between an alignment central portion of the substrate 101 and a neighborhood of a central aperture of the piezoelectric actuator 102. In response to an applied voltage, the piezoelectric actuator 102 is subjected to deformation and a fluid is driven to flow through various chambers of the fluid control device 100. In such way, the purpose of transporting the fluid is achieved.

The piezoelectric actuator 102 and the substrate 101 of the fluid control device 100 are both flat-plate structures with certain rigidities. Thus, it is difficult to precisely align these two flat-plate structures to make the specified gap 103 and maintain it. If the gap 103 was not maintained in the specified depth, an assembling error would occur. Further explanation is exemplified as below. Referring to FIG. 1B, the piezoelectric actuator 102 is inclined at an angle θ by one side as a pivot. Most regions of the piezoelectric actuator 102 deviate from the expected horizontal position by an offset, and the offset of each point of the regions is correlated positively with its parallel distance to the pivot. In other words, slight deflection can cause a certain amount of deviation. As shown in FIG. 1B, one indicated region of the piezoelectric actuator 102 deviates from the standard by d while another indicated region can deviate by d'. As the fluid control device is developed toward miniaturization, miniature components are adopted. Consequently, the difficulty of maintaining the specified depth of the gap 103 has increased. The failure of maintaining the depth of the gap 103 causes several problems. For example, if the gap 103 is increased by d', the fluid transportation efficiency is reduced. On the other hand, if the gap 103 is decreased by d', the distance of the gap 103 is shortened and is unable to prevent the piezoelectric actuator 102from readily being contacted or interfered by other components during operation. Under this circumstance, noise is generated, and the performance of the fluid control device is reduced.

Since the piezoelectric actuator 102 and the substrate 101 of the fluid control device 100 are flat-plate structures with certain rigidities, it is difficult to precisely align these two flat-plate structures. Especially when the sizes of the components are gradually decreased, the difficulty of precisely aligning the miniature components is largely enhanced. Under this circumstance, the performance of transferring the fluid is deteriorated, and the unpleasant noise is generated.

Therefore, there is a need of providing an improved fluid control device in order to eliminate the above drawbacks.

### SUMMARY OF THE INVENTION

The present invention provides a fluid control device. The fluid control device has a miniature substrate and a miniature piezoelectric actuator. Since the substrate is deformable, a specified depth between a flexible plate of the substrate and a vibration plate of the piezoelectric actuator is maintained. Consequently, the assembling error is reduced, the efficiency of transferring the fluid is enhanced, and the noise is reduced. That is, the fluid control device of the present invention is more user-friendly.

In accordance with an aspect of the present invention, there is provided a manufacturing method of a fluid control device. Firstly, a housing, a piezoelectric actuator and a deformable substrate are provided. The piezoelectric actuator includes a piezoelectric element, an outer frame, at least one bracket and a vibration plate. The deformable substrate includes a flexible plate and a communication plate, wherein the communication plate comprises at least one inlet, the housing comprises at least one outlet. The flexible plate includes a movable part and a central aperture. Then, the flexible plate and the communication plate are stacked on each other and coupled, and a preformed synchronous deformation process is implemented. Consequently, a preformed synchronously-deformed structure is defined by the flexible plate and the communication plate collaboratively. Then, the housing, the piezoelectric actuator and the deformable substrate are sequentially stacked and coupled. The preformed synchronously-deformed structure of the deformable substrate is aligned with the bulge of the vibration plate. Consequently, a specified depth between the movable part of the flexible plate and the bulge of the vibration plate is defined.

In accordance with preferred embodiment of the present invention, the vibration plate has a first surface and an opposing second surface. A bulge is formed on the second surface of the vibration plate. The preformed synchronously-deformed structure is aligned with with the bulge of the vibration plate to define the specified depth between the movable part of the flexible plate and the bulge of the vibration plate.

The above contents of the present invention will become more readily apparent to those ordinarily skilled in the art after reviewing the following detailed description and accompanying drawings, in which:

### BRIEF DESCRIPTION OF THE DRAWINGS

FIG. 1A is a schematic cross-sectional view illustrating a portion of a conventional fluid control device;
FIG. 1B is a schematic cross-sectional view illustrating an assembling shift condition of the conventional fluid control device;
FIG. 2 is a flowchart illustrating a manufacturing method of a fluid control device according to an embodiment of the present invention;
FIG. 3A is a schematic cross-sectional view of the fluid control device according to an embodiment of the present invention;
FIG. 3B is a schematic cross-sectional view illustrating the action of the fluid control device of FIG. 3A;
FIG. 4A is a schematic cross-sectional view illustrating a first example of the preformed synchronously-deformed structure of the deformable substrate of the fluid control device;
FIG. 4B is a schematic cross-sectional view illustrating a second example of the preformed synchronously-deformed structure of the deformable substrate of the fluid control device;
FIG. 4C is a schematic cross-sectional view illustrating a third example of the preformed synchronously-deformed structure of the deformable substrate of the fluid control device;
FIG. 4D is a schematic cross-sectional view illustrating a fourth example of the preformed synchronously-deformed structure of the deformable substrate of the fluid control device;
FIG. 5A is a schematic cross-sectional view illustrating a fifth example of the preformed synchronously-deformed structure of the deformable substrate of the fluid control device;
FIG. 5B is a schematic cross-sectional view illustrating a sixth example of the preformed synchronously-deformed structure of the deformable substrate of the fluid control device;
FIG. 5C is a schematic cross-sectional view illustrating a seventh example of the preformed synchronously-deformed structure of the deformable substrate of the fluid control device
FIG. 5D is a schematic cross-sectional view illustrating an eighth example of the preformed synchronously-deformed structure of the deformable substrate of the fluid control device;
FIG. 6A is a schematic cross-sectional view illustrating a ninth example of the preformed synchronously-deformed structure of the deformable substrate of the fluid control device;
FIG. 6B is a schematic cross-sectional view illustrating a tenth example of the preformed synchronously-deformed structure of the deformable substrate of the fluid control device;
FIG. 6C is a schematic cross-sectional view illustrating an eleventh example of the preformed synchronously-deformed structure of the deformable substrate of the fluid control device;
FIG. 6D is a schematic cross-sectional view illustrating a twelfth example of the preformed synchronously-deformed structure of the deformable substrate of the fluid control device;
FIG. 7 is a schematic cross-sectional view illustrating a thirteenth example of the preformed synchronously-deformed structure of the deformable substrate of the fluid control device; and
FIG. 8 is a flowchart illustrating a manufacturing method of a fluid control device according to another embodiment of the present invention.

### DETAILED DESCRIPTION OF THE PREFERRED EMBODIMENT

The present invention will now be described more specifically with reference to the following embodiments. It is to be noted that the following descriptions of preferred embodiments of this invention are presented herein for purpose of illustration and description only. It is not intended to be exhaustive or to be limited to the precise form disclosed.

The present invention provides a manufacturing method of a fluid control device. The fluid control device can be used in many sectors such as pharmaceutical industries, energy industries computer techniques or printing industries for transporting fluids.

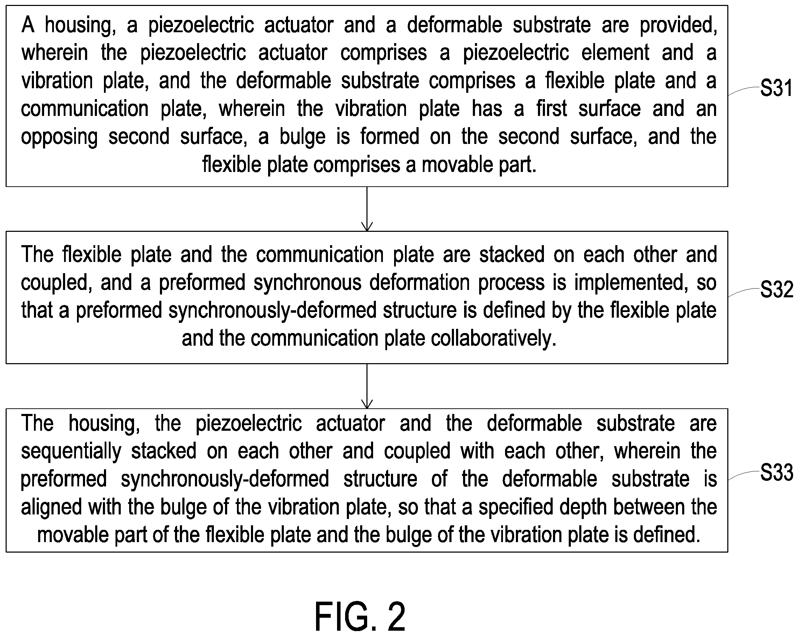

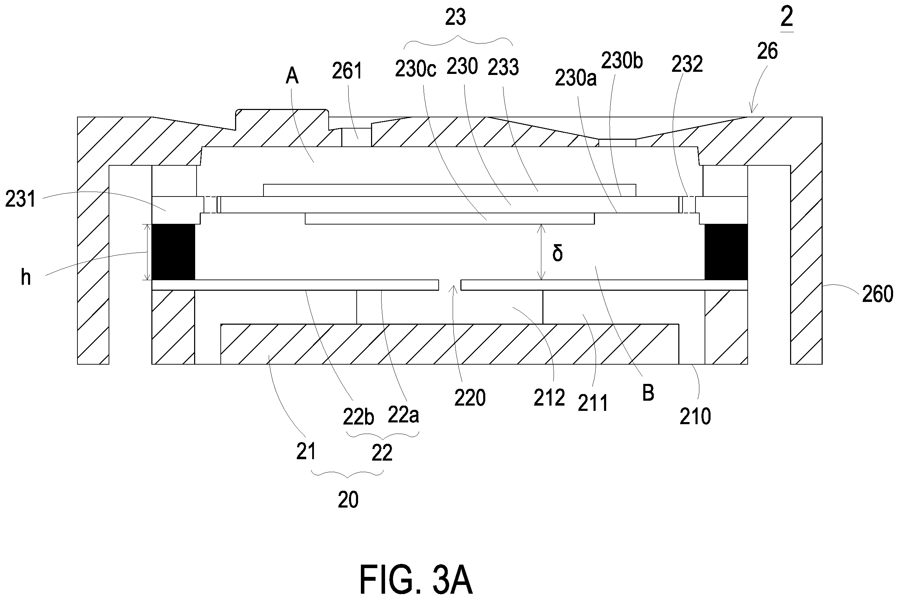

FIG. 2 is a flowchart illustrating a manufacturing method of a fluid control device according to an embodiment of the present invention. FIG. 3A is a schematic cross-sectional view of the fluid control device according to an embodiment of the present invention. Please refer to FIGS. 2 and 3A. In a step S31, a housing 26, a piezoelectric actuator 23 and a deformable substrate 20 are provided. The piezoelectric actuator 23 comprises a vibration plate 230 and a piezoelectric element 233. The vibration plate 230 has a first surface 230b and an opposing second surface 230a. Moreover, a bulge 230c is formed on the second surface 230a of the vibration plate 230. In this embodiment, the vibration plate 230 has a square flexible film structure. The piezoelectric element 233 has a square shape. The side length of the piezoelectric element 233 is not larger than the side length of the vibration plate 230. Moreover, the piezoelectric element 233 is attached on the first surface 230b of the vibration plate 230. By applying a voltage to the piezoelectric element 233, the piezoelectric element 233 is subjected to deformation to result in curvy vibration of the vibration plate 230. The piezoelectric actuator 23 further comprises an outer frame 231 and at least one bracket 232. The vibration plate 230 is enclosed by the outer frame 231. The profile of the outer frame 231 matches the profile of the vibration plate 230. That is, the outer frame 231 is a square hollow frame. Moreover, the at least one bracket 232 is connected between the vibration plate 230 and the outer frame 231 for elastically supporting the vibration plate 230. The deformable substrate 20 comprises a communication plate 21 and a flexible plate 22. The communication plate 21 has an outer surface 21a. The communication plate 21 comprises at least one inlet 210, at least one convergence channel 211 and a central cavity 212. The inlet 210 runs through the communication plate 21. A fist end of the convergence channel 211 is in communication with the inlet 210, while a second end of the convergence channel 211 is in communication with the central cavity 212. The flexible plate 22 comprises a movable part 22a and a fixed part 22b. The fixed part 22b is fixed on the communication plate 21 in order to connect the flexible plate 22 with the communication plate 21. The movable part 22a is aligned with the central cavity 212. A central aperture 220 is formed within the movable part 22a and aligned with the central cavity 212 of the communication plate 21. The housing 26 comprises at least one outlet 261. Furthermore, the housing 26 can be a single plate or a frame consists of a bottom plate and a sidewall structure 260, wherein the sidewall structure 260 extends from the peripheral of the bottom plate. An accommodation space is defined by the bottom plate and the sidewall structure 260 collaboratively. The piezoelectric actuator 23 is disposed within the accommodation space. The piezoelectric actuator 23 and the deformable substrate 20 are covered by the housing 26. In addition, a temporary storage chamber A is formed between the housing 26 and the piezoelectric actuator 23 for temporarily storing the fluid. The outlet 261 is in communication with the temporary storage chamber A. Consequently, the fluid can be discharged to exterior of the housing 26 from interior of the housing 26 through the outlet 261.

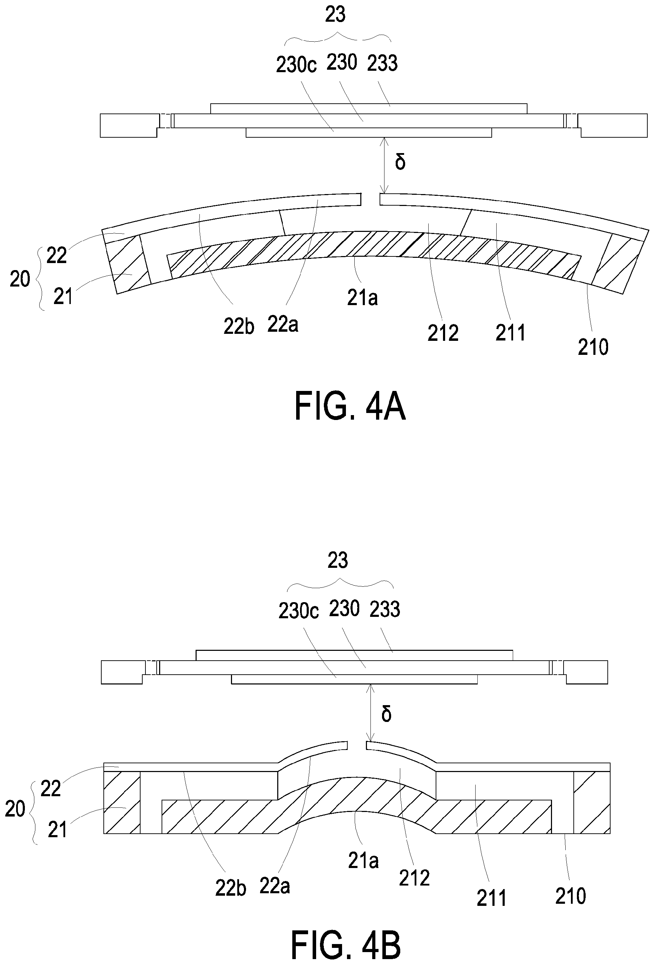

In a step S32, the flexible plate 22 and the communication plate 21 are stacked on and coupled with each other. Then, a preformed synchronous deformation process is implemented. As a consequence, a preformed synchronously-deformed structure is defined by the flexible plate 22 and the communication plate 21 collaboratively. The preformed synchronous deformation process can involve or not involve an external force. In the latter case, the inner structure of the deformable substrate 20 is changed in response of a change of temperature or other factors, and the outer structure of the deformable substrate 20 is correspondingly subjected to deformation. That is, the preformed synchronous deformation process is implemented in response to thermal expansion or cold shrink so that the structure of the deformable substrate 20 is changed without involving external force. Consequently, the preformed synchronously-deformed structure is formed (see FIGS. 4A to 7). By contrast, at least one external force, which is preferably but not exclusively a contact force, is applied to the at least one surface of the deformable substrate 20 in the preformed synchronous deformation process. By applying one or more external force to the surface of the deformable substrate 20, the deformable substrate 20 is subjected to synchronous deformation and the preformed synchronously-deformed structure is consequently formed. In addition, a mark (not shown) caused by such force may be formed on a surface of the preformed synchronously-deformed structure. In some embodiments, the at least one external force is a non-contact force. For example, a suction force generated by a vacuum aspirator or a magnetic attraction force. When the vacuum suction force or the magnetic attraction force is applied to the deformable substrate 20, the deformable substrate 20 is subjected to the synchronous deformation and the preformed synchronously-deformed structure is consequently formed.

In a step S33, the housing 26, the piezoelectric actuator 23 and the deformable substrate 20 are sequentially stacked on each other, and coupled with each other. The preformed synchronously-deformed structure of the deformable substrate 20 is aligned with the bulge 230c of the vibration plate 230. Consequently, a specified depth δ is defined between the movable part 22a of the flexible plate 22 and the bulge 230c of the vibration plate 230. In this step, the piezoelectric actuator 23 is covered by the housing 26 (see FIG. 3A).

Please refer to FIG. 3A. The deformable substrate 20 shown in FIG. 3A has not been subjected to the synchronous deformation, while FIG. 3A is used for describing the stacked structure of the fluid control device 2. After the piezoelectric actuator 23 is received within an accommodation space 26a of the housing 26, the deformable substrate 20 or the preformed synchronously-deformed structure of the deformable substrate 20 is combined with the piezoelectric actuator 23 and collectively received within the accommodation space 26a, therefore sealing the bottom of the piezoelectric actuator 23. In the process of assembling, the movable part 22a of the flexible plate 22 and the bulge 230c of the piezoelectric actuator 23 are aligned. Moreover, the preformed synchronously-deformed structure of the deformable substrate 20 is bent in the direction toward or away the bulge 230c of the vibration plate 230 so that the specified depth δ is defined between the movable part 22a of the flexible plate 22 and the bulge 230c of the vibration plate 230. Consequently, the fluid control device 2 with the preformed synchronously-deformed structure is produced.

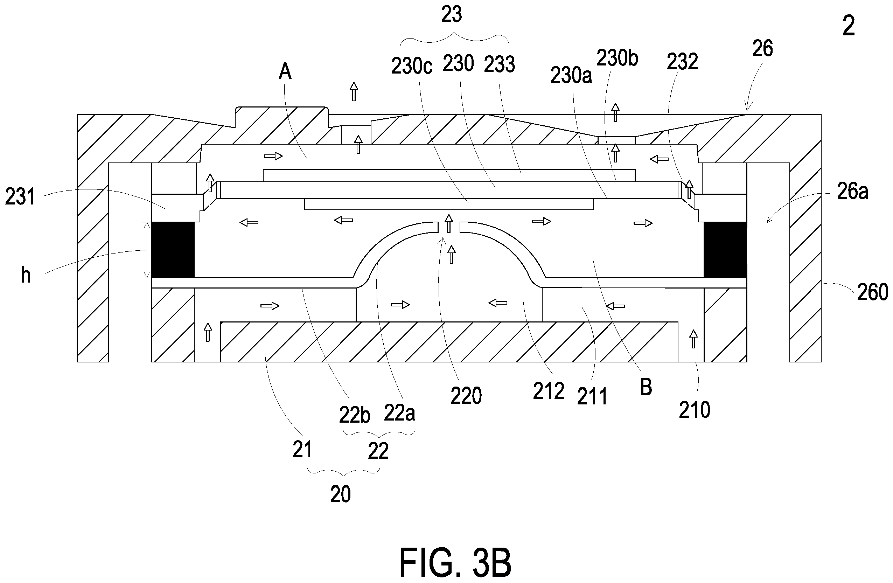

FIG. 3B is a schematic cross-sectional view illustrating the action of the fluid control device of FIG. 3A. Please refer to FIGS. 3A and 3B. After the communication plate 21, the flexible plate 22 and the piezoelectric actuator 23 are coupled together, a convergence chamber is defined by partial flexible plate 22 including the central aperture 220 within, and the central cavity 212 of the communication plate 21 collaboratively. There is a gap h between the flexible plate 22 and the outer frame 231 of the piezoelectric actuator 23. Preferably but not exclusively, a medium (e.g., a conductive adhesive) is filled in the gap h. Consequently, the flexible plate 22 and the outer frame 231 of the piezoelectric actuator 23 are connected with each other through the medium. At the same time, the specified depth δ is defined between the movable part 22a of the flexible plate 22 and the bulge 230c of the piezoelectric actuator 23. When the vibration plate 230 of the piezoelectric actuator 23 vibrates, the fluid in a compressible chamber B defined between the flexible plate 22 and the piezoelectric actuator 23 is compressed, while the specified depth δ reduces due to the transformation of the flexible plate 22. Consequently, the pressure and the flow rate of the fluid are increased. The specified depth δ is a proper distance that is sufficient to reduce the contact interference between the movable part 22a of the flexible plate 22 and the bulge 230c of the piezoelectric actuator 23, thus reducing the noise generation. Moreover, the convergence chamber defined by the flexible plate 22 and the central cavity 212 of the communication plate 21 is in communication with the compressible chamber B through the central aperture 220.

When the fluid control device 2 is enabled, the piezoelectric element 233 of the piezoelectric actuator 23 is actuated in response to an applied voltage. Consequently, the vibration plate 230 of the piezoelectric actuator 23 vibrates along a vertical direction in a reciprocating manner. When the vibration plate 230 vibrates upwardly in response to the applied voltage, since the flexible plate 22 is light and thin, the flexible plate 22 vibrates simultaneously because of the resonance of the vibration plate 230. More especially, the movable part 22a of the flexible plate 22 is subjected to a curvy deformation. The central aperture 220 is located near or located at the center of the flexible plate 22. Since the vibration plate 230 vibrates upwardly, the movable part 22a of the flexible plate 22 correspondingly moves upwardly, making an external fluid introduced by the at least one inlet 210, through the at least one convergence channel 211, into the convergence chamber. After that, the fluid is transferred upwardly to the compressible chamber B through the central aperture 220 of the flexible plate 22. As the flexible plate 22 is subjected to deformation, the volume of the compressible chamber B is compressed such that it enhances the kinetic energy of the fluid therein and makes it flow to the bilateral sides, and then transferred upwardly through the vacant space between the vibration plate 230 and the bracket 232. As the vibration plate 230 vibrates downwardly, the movable part 22a of the flexible plate 22 correspondingly moves downwardly and subjected to the downward curvy deformation because of the resonance of the vibration plate 230. Meanwhile, less fluid is converged to the convergence chamber in the central cavity 212 of the communication plate 21. Since the piezoelectric actuator 23 vibrates downwardly, the volume of the compressible chamber B is increased. Above-mentioned actions depicted in FIG. 3B are repeatedly done so as to expand or compress the compressible chamber B, thus enlarging the amount of inhalation or discharge of the fluid.

As mentioned above, the deformable substrate 20 is made by stacking and coupling the communication plate 21 and the flexible plate 22. The preformed synchronously-deformed structure is defined by the communication plate 21 and the flexible plate 22 collaboratively. Specifically, the preformed synchronously-deformed structure is defined by a synchronously-deformed region of the communication plate 21 and a synchronously-deformed region of the flexible plate 22 collaboratively. When one of the communication plate 21 and the flexible plate 22 is subjected to deformation, another is also subjected to deformation synchronously. Moreover, the deformation shape of the communication plate 21 and the deformation shape of the flexible plate 22 are identical. As a result, after the corresponding surfaces of the communication plate 21 and the flexible plate 22 are contacted with and positioned on each other, there is merely little interval or parallel offset happened therebetween. As previously described, the piezoelectric actuator and the substrate of the conventional fluid control device are flat-plate structures with certain rigidities. Consequently, it is difficult to precisely align these two flat-plate structures and make them separated by the specified gap (i.e., maintain the specified depth). That is, the misalignment of the piezoelectric actuator and the substrate could readily occur. In accordance with the present invention, the preformed synchronously-deformed structure of the deformable substrate 20 is defined in response to the synchronous deformation of the communication plate 21 and the flexible plate 22. Moreover, the function of the preformed synchronously-deformed structure is similar to the function of the substrate of the conventional technology. More especially, the preformed synchronously-deformed structure defined by the communication plate 21 and the flexible plate 22 has various implementation examples. In these implementation examples, a compressible chamber B corresponding to the specified depth δ (i.e., a specified gap between the preformed synchronously-deformed structure and the vibration plate 230 of the piezoelectric actuator 23) is maintained according to the practical requirements. Consequently, the fluid control device 2 is developed toward miniaturization, and the miniature components are adopted. Due to the preformed synchronously-deformed structure, it is easy to maintain the specified gap between the deformable substrate and the vibration plate. As previously described, the conventional technology has to precisely align two large-area flat-plate structures. In accordance with the feature of the present invention, the area to be aligned reduces because the deformable substrate 20 has the synchronously-deformed structure and is a not a flat plate. The shape of the synchronously-deformed structure is not restricted. For example, the synchronously-deformed structure has a curvy shape, a conical shape, a curvy-surface profile or an irregular shape. Compared with aligning two large areas of the two flat plates, aligning one small area of a non-flat-plate with a flat plate is much easier, and therefore reduces assembling errors. Under this circumstance, the performance of transferring the fluid is enhanced and the noise is reduced.

Preferably but not exclusively, the preformed synchronously-deformed structure has a curvy shape, a conical shape, a curvy-surface profile or an irregular shape. Some examples of the preformed synchronously-deformed structure will be described as follows.

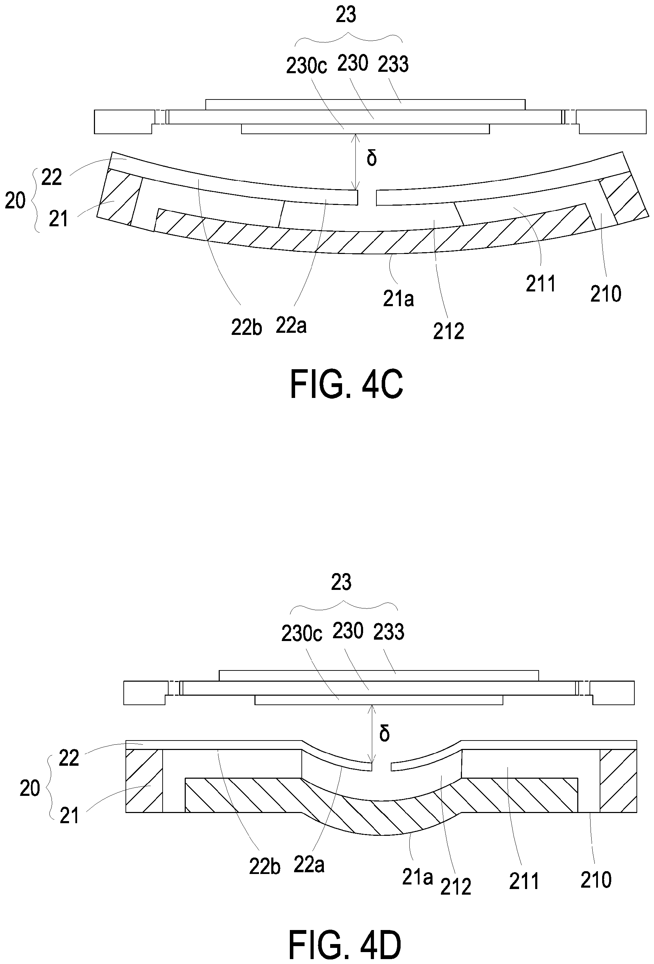

Please refer to FIGS .4A and 4C. FIG. 4A is a schematic cross-sectional view illustrating a first example of the preformed synchronously-deformed structure of the deformable substrate of the fluid control device. FIG. 4C is a schematic cross-sectional view illustrating a third example of the preformed synchronously-deformed structure of the deformable substrate of the fluid control device. In the examples of FIGS. 4A and 4C, the preformed synchronously-deformed structure is defined by the entire communication plate 21 and the entire flexible plate 22 collaboratively. That is, the synchronously-deformed region of the flexible plate 22 includes the movable part 22a and the region beyond the movable part 22a. The deformation direction of the example of FIG. 4A and the deformation direction of the example of FIG. 4C are opposite. As shown in FIG. 4A, the outer surface 21a of the communication plate 21 of the deformable substrate 20 is bent in the direction toward the bulge 230c of the vibration plate 230. Moreover, the movable part 22a and the region beyond the movable part 22a of the flexible plate 22 are also bent in the direction toward the bulge 230c of the vibration plate 230. The bent communication plate 21 and the bent flexible plate 22 define the preformed synchronously-deformed structure of the deformable substrate 20. As shown in FIG. 4C, the outer surface 21a of the communication plate 21 of the deformable substrate 20 is bent in the direction away from the bulge 230c of the vibration plate 230. Simultaneously, the movable part 22a and the region beyond the movable part 22a of the flexible plate 22 are also bent in the direction away from the bulge 230c of the vibration plate 230. As a consequence, the preformed synchronously-deformed structure of the deformable substrate 20 is defined. Under this circumstance, the specified depth δ is defined and maintained between the movable part 22a of the flexible plate 22 and the bulge 230c of the vibration plate 230. Consequently, the fluid control device 2 with the preformed synchronously-deformed structure is produced.

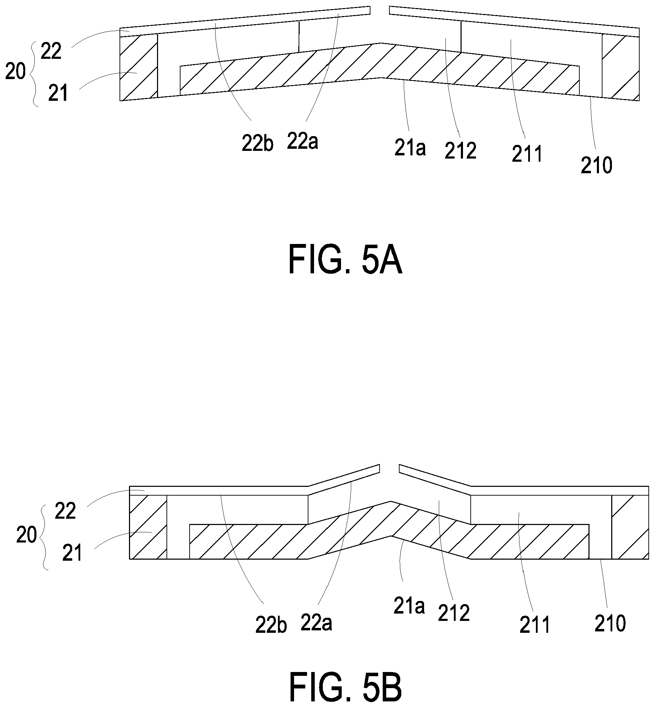

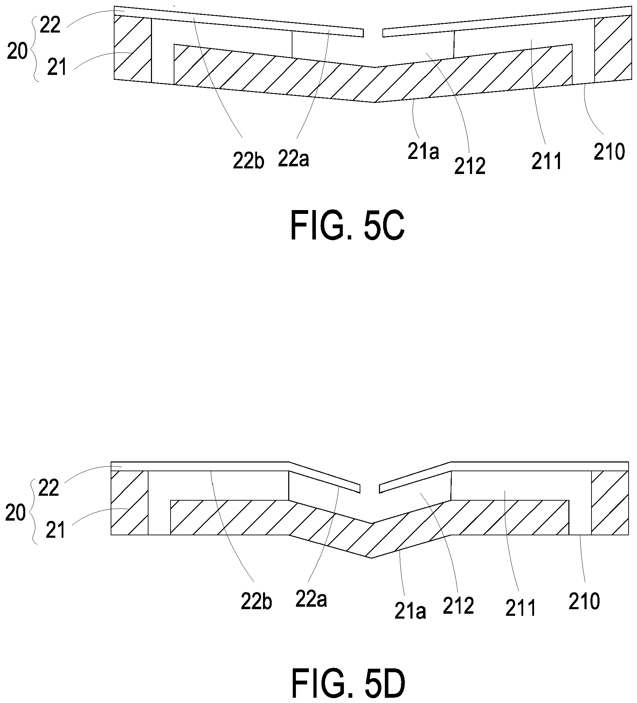

Please refer to FIGS. 5A and 5C. FIG. 5A is a schematic cross-sectional view illustrating a fifth example of the preformed synchronously-deformed structure of the deformable substrate of the fluid control device. FIG. 5C is a schematic cross-sectional view illustrating a seventh example of the preformed synchronously-deformed structure of the deformable substrate of the fluid control device. In the examples of FIGS. 5A and 5C, the preformed synchronously-deformed structure is a conical synchronously-deformed structure that is defined by the entire communication plate 21 and the entire flexible plate 22 collaboratively. That is, the synchronously-deformed region of the flexible plate 22 includes the movable part 22a and the region beyond the movable part 22a of the flexible plate 22. The deformation direction of the example of FIG. 5A and the deformation direction of the example of FIG. 5C are opposite. As shown in FIG. 5A, the outer surface 21a of the communication plate 21 of the deformable substrate 20 is bent in the direction toward the bulge 230c of the vibration plate 230. Moreover, the movable part 22a and the region beyond the movable part 22a of the flexible plate 22 are also bent in the direction toward the bulge 230c of the vibration plate 230. As a consequence, the conical synchronously-deformed structure of the deformable substrate 20 is defined. As shown in FIG. 5C, the outer surface 21a of the communication plate 21 of the deformable substrate 20 is bent in the direction away from the bulge 230c of the vibration plate 230. Moreover, the movable part 22a and the region beyond the movable part 22a of the flexible plate 22 are also bent in the direction away from the bulge 230c of the vibration plate 230. As a consequence, the conical synchronously-deformed structure of the deformable substrate 20 is defined. Under this circumstance, the specified depth δ is defined and maintained between the movable part 22a of the flexible plate 22 and the bulge 230c of the vibration plate 230. Consequently, the fluid control device 2 with the conical synchronously-deformed structure is produced.

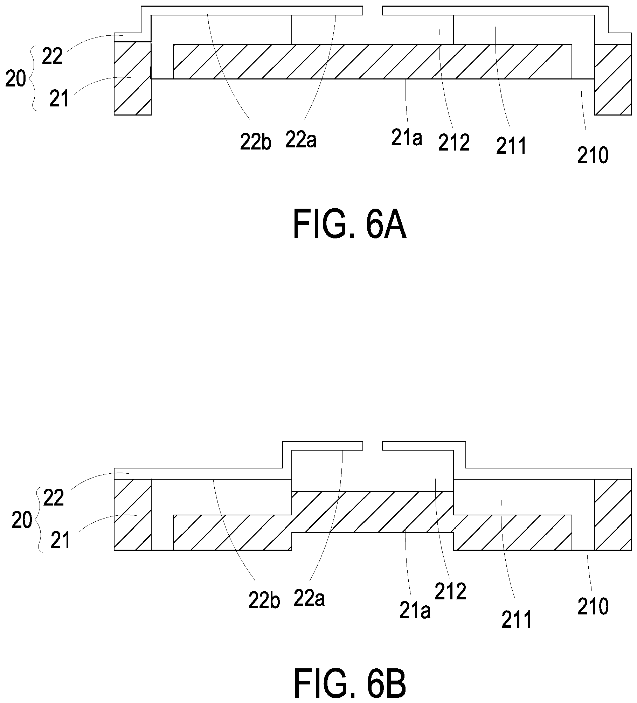

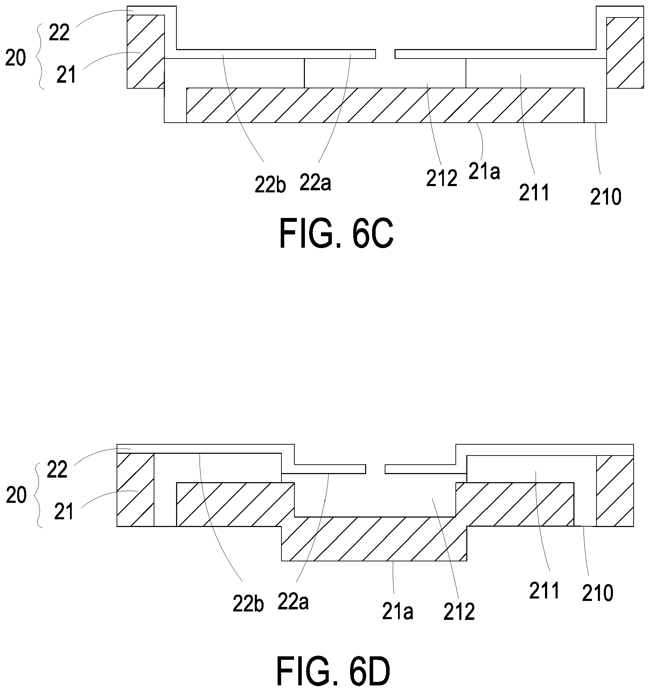

Please refer to FIGS. 6A and 6C. FIG. 6A is a schematic cross-sectional view illustrating a ninth example of the preformed synchronously-deformed structure of the deformable substrate of the fluid control device. FIG. 6C is a schematic cross-sectional view illustrating an eleventh example of the preformed synchronously-deformed structure of the deformable substrate of the fluid control device. In the examples of FIGS. 6A and 6C, the preformed synchronously-deformed structure is a convex synchronously-deformed structure that is defined by the entire communication plate 21 and the entire flexible plate 22 collaboratively. That is, the convex synchronously-deformed region of the flexible plate 22 includes the movable part 22a and the region beyond the movable part 22a. The deformation direction of the example of FIG. 6A and the deformation direction of the example of FIG. 6C are opposite. As shown in FIG. 6A, the outer surface 21a of the communication plate 21 of the deformable substrate 20 is bent in the direction toward the bulge 230c of the vibration plate 230. Moreover, the movable part 22a and the region beyond the movable part 22a of the flexible plate 22 are also bent in the direction toward the bulge 230c of the vibration plate 230. As a consequence, the convex synchronously-deformed structure of the deformable substrate 20 is defined. As shown in FIG. 6C, the outer surface 21a of the communication plate 21 of the deformable substrate 20 is bent in the direction away from the bulge 230c of the vibration plate 230. Moreover, the movable part 22a and the region beyond the movable part 22a of the flexible plate 22 are also bent in the direction away from the bulge 230c of the vibration plate 230. As a consequence, the convex synchronously-deformed structure of the deformable substrate 20 is defined. Under this circumstance, the specified depth δ is defined and maintained between the movable part 22a of the flexible plate 22 and the bulge 230c of the vibration plate 230. Consequently, the fluid control device 2 with the convex synchronously-deformed structure is produced.

Alternatively, the preformed synchronously-deformed structure is defined by a part of the communication plate 21 and a part of the flexible plate 22 collaboratively. That is, the synchronously-deformed region of the flexible plate 22 includes the region of the movable part 22a only, and the scale of the synchronously-deformed region of the communication plate 21 corresponds to the synchronously-deformed region of the flexible plate 22. In addition, the synchronously-deformed structure of the deformable substrate 20 includes but not limited to a curvy structure, a conical structure and a convex structure.

Please refer to FIGS. 4B and 4D. FIG. 4B is a schematic cross-sectional view illustrating a second example of the preformed synchronously-deformed structure of the deformable substrate of the fluid control device. FIG. 4D is a schematic cross-sectional view illustrating a fourth example of the preformed synchronously-deformed structure of the deformable substrate of the fluid control device. In the examples of FIGS. 4B and 4D, the preformed synchronously-deformed structure is defined by a part of the communication plate 21 and a part of the flexible plate 22 collaboratively. The synchronously-deformed region of the flexible plate 22 includes the region of the movable part 22a only, and the synchronously-deformed region of the communication plate 21 corresponds to the synchronously-deformed region of the flexible plate 22. That is, the synchronously-deformed structures of FIGS. 4B and 4D are produced by partially deforming the deformable substrate 20. The deformation direction of the example of FIG. 4B and the deformation direction of the example of FIG. 4D are opposite. As shown in FIG. 4B, the outer surface 21a of the communication plate 21 of the deformable substrate 20 is partially bent in the direction toward the bulge 230c of the vibration plate 230. Moreover, the region of the movable part 22a of the flexible plate 22 is also partially bent in the direction toward the bulge 230c of the vibration plate 230. As a consequence, the partially-bent synchronously-deformed structure of the deformable substrate 20 is defined. As shown in FIG. 4D, the outer surface 21a of the communication plate 21 of the deformable substrate 20 is partially bent in the direction away from the bulge 230c of the vibration plate 230. Moreover, the region of the movable part 22a of the flexible plate 22 is also partially bent in the direction away from the bulge 230c of the vibration plate 230. As a consequence, the partially-bent synchronously-deformed structure of the deformable substrate 20 is defined. Under this circumstance, the specified depth δ is defined and maintained between the movable part 22a of the flexible plate 22 and the bulge 230c of the vibration plate 230. That is, the specified depth δ between the movable part 22a of the flexible plate 22 and the bulge 230c of the vibration plate 230 is maintained. Consequently, the fluid control device 2 with the partially-bent synchronously-deformed structure is produced.

Please refer to FIGS. 5B and 5D. FIG. 5B is a schematic cross-sectional view illustrating a sixth example of the preformed synchronously-deformed structure of the deformable substrate of the fluid control device. FIG. 5D is a schematic cross-sectional view illustrating an eighth example of the preformed synchronously-deformed structure of the deformable substrate of the fluid control device. In the examples of FIGS. 5B and 5D, the preformed synchronously-deformed structure is defined by a part of the communication plate 21 and a part of the flexible plate 22 collaboratively. The synchronously-deformed region of the flexible plate 22 includes the region of the movable part 22a only, and the synchronously-deformed region of the communication plate 21 corresponds to the synchronously-deformed region of the flexible plate 22. That is, the synchronously-deformed structures of FIGS. 5B and 5D are produced by partially deforming the deformable substrates 20 to conical synchronously-deformed structures. The deformation direction of the example of FIG. 5B and the deformation direction of the example of FIG. 5D are opposite. As shown in FIG. 5B, the outer surface 21a of the communication plate 21 of the deformable substrate 20 is partially bent in the direction toward the bulge 230c of the vibration plate 230. Moreover, the region of the movable part 22a of the flexible plate 22 is also partially bent in the direction toward the bulge 230c of the vibration plate 230. As a consequence, the conical synchronously-deformed structure of the deformable substrate 20 is defined. As shown in FIG. 5D, the outer surface 21a of the communication plate 21 of the deformable substrate 20 is partially bent in the direction away from the bulge 230c of the vibration plate 230. Moreover, the region of the movable part 22a of the flexible plate 22 is also partially bent in the direction away from the bulge 230c of the vibration plate 230. As a consequence, the conical synchronously-deformed structure of the deformable substrate 20 is defined. Under this circumstance, the specified depth δ is defined and maintained between the movable part 22a of the flexible plate 22 and the bulge 230c of the vibration plate 230. Consequently, the fluid control device 2 with the conical synchronously-deformed structure is produced.

Please refer to FIGS. 6B and 6D. FIG. 6B is a schematic cross-sectional view illustrating a tenth example of the preformed synchronously-deformed structure of the deformable substrate of the fluid control device. FIG. 6D is a schematic cross-sectional view illustrating a twelfth example of the preformed synchronously-deformed structure of the deformable substrate of the fluid control device. In the examples of FIGS. 6B and 6D, the preformed synchronously-deformed structure is defined by a part of the communication plate 21 and a part of the flexible plate 22 collaboratively. The synchronously-deformed region of the flexible plate 22 includes the region of the movable part 22a only, and the synchronously-deformed region of the communication plate 21 corresponds to the synchronously-deformed region of the flexible plate 22. That is, the preformed synchronously-deformed structures of FIGS. 6B and 6D are produced by partially deforming the deformable substrates 20 to the convex synchronously-deformed structures. The deformation direction of the example of FIG. 6B and the deformation direction of the example of FIG. 6D are opposite. As shown in FIG. 6B, the outer surface 21a of the communication plate 21 of the deformable substrate 20 is partially bent in the direction toward the bulge 230c of the vibration plate 230. Moreover, the region of the movable part 22a of the flexible plate 22 is also partially bent in the direction toward the bulge 230c of the vibration plate 230. As a consequence, the convex synchronously-deformed structure of the deformable substrate 20 is defined. As shown in FIG. 6D, the outer surface 21a of the communication plate 21 of the deformable substrate 20 is partially bent in the direction away from the bulge 230c of the vibration plate 230. Moreover, the region of the movable part 22a of the flexible plate 22 is also partially bent in the direction away from the bulge 230c of the vibration plate 230. As a consequence, the convex synchronously-deformed structure of the deformable substrate 20 is defined. Under this circumstance, the specified depth δ is defined and maintained between the movable part 22a of the flexible plate 22 and the bulge 230c of the vibration plate 230. Consequently, the fluid control device 2 with the convex synchronously-deformed structure is produced.

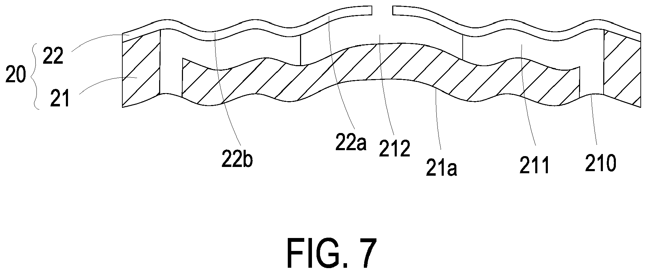

FIG. 7 is a schematic cross-sectional view illustrating an example of the synchronously-deformed structure of the deformable substrate of the fluid control device. The preformed synchronously-deformed structure also can be a curvy-surface synchronously-deformed structure, which is composed of plural curvy surfaces with different or identical curvatures. As shown in FIG. 7, the curvy-surface synchronously-deformed structure comprises plural curvy surfaces with different curvatures. A set of the plural curvy surfaces are formed on the outer surface 21a of the communication plate 21 of the deformable substrate 20, while another set of curvy surfaces corresponding to the former set are formed on the flexible plate 22. Under this circumstance, the specified depth δ is defined and maintained between the curvy-surface synchronously-deformed structure and the bulge 230c of the vibration plate 230. Consequently, the fluid control device 2 with the curvy-surface synchronously-deformed structure is produced.

In some other embodiments, the preformed synchronously-deformed structure is an irregular synchronously-deformed structure, which is produced by making two sets of identical irregular surfaces respectively on the communication plate 21 and the flexible plate 22 of the deformable substrate 20. Consequently, the irregular synchronously-deformed structure is defined by the communication plate 21 and the flexible plate 22. The preformed synchronously-deformed structure is bent in the direction toward or away the bulge 230c of the vibration plate 230. Under this circumstance, the specified depth δ is defined and maintained between the synchronously-deformed structure and the bulge 230c of the vibration plate 230.

It is noted that numerous modifications and alterations may be made while retaining the teachings of the invention. For example, the preformed synchronously-deformed structure may be varied according to the practical requirements.

In some embodiments, the vibration plate 230 of the piezoelectric actuator 23 is not equipped with the bulge 230. That is, the second surface 230a of the vibration plate 230 is a flat surface. The gap between the deformable substrate 20 and the piezoelectric actuator 23 is equal to the distance between the flexible plate 22 of the deformable substrate 20 and the second surface 230a of the vibration plate 230. A preformed synchronously-deformed structure of the deformable substrate 20 is produced after the fluid control device is assembled, and a specified depth δ is defined and maintained between the preformed synchronously-deformed structure and the vibration plate 230. The specified depth δ is sufficient to reduce the contact interference between the flexible plate 22 and the vibration plate 230 of the piezoelectric actuator 23. Consequently, the efficiency of transferring the fluid is enhanced, and the noise is reduced.

The shape of the preformed synchronously-deformed structure is not restricted. For example, the preformed synchronously-deformed structure has a curvy shape, a conical shape, a curvy-surface profile or an irregular shape.

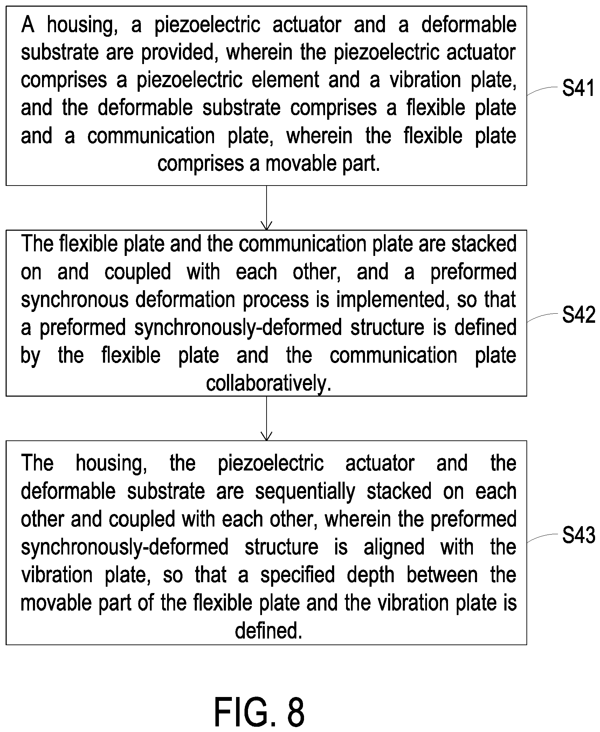

As mentioned above, the vibration plate 230 of the piezoelectric actuator 23 may not be equipped with the bulge 230. FIG. 8 is a flowchart illustrating a manufacturing method of a fluid control device according to another embodiment of the present invention. In a step S41, a housing 26, a piezoelectric actuator 23 and a deformable substrate 20 are provided. The piezoelectric actuator 23 comprises a vibration plate 230 and a piezoelectric element 233. The vibration plate 230 has a first surface 230b and an opposing second surface 230a. In this embodiment, the vibration plate 230 has a square flexible film structure. The piezoelectric element 233 has a square shape. The side length of the piezoelectric element 233 is not larger than the side length of the vibration plate 230. Moreover, the piezoelectric element 233 is attached on the first surface 230b of the vibration plate 230. By applying a voltage to the piezoelectric element 233, the piezoelectric element 233 is subjected to deformation to result in curvy vibration of the vibration plate 230.

In a step S42, the flexible plate 22 and the communication plate 21 are stacked on and coupled with each other. Then, a preformed synchronous deformation process is implemented. As a consequence, a preformed synchronously-deformed structure is defined by the flexible plate 22 and the communication plate 21 collaboratively. The preformed synchronous deformation process can involve or not involve an external force. In the latter case, the inner structure of the deformable substrate 20 is changed in response of a change of temperature or other factors, and the outer structure of the deformable substrate 20 is correspondingly subjected to deformation. That is, the preformed synchronous deformation process is implemented in response to thermal expansion or cold shrink so that the structure of the deformable substrate 20 is changed without involving external force. Consequently, the preformed synchronously-deformed structure is formed (see FIGS. 4A to 7). By contrast, at least one external force, which is preferably but not exclusively a contact force, is applied to at least one surface of the deformable substrate 20 in the preformed synchronous deformation process. By applying one or more external force to the surface of the deformable substrate 20, the deformable substrate 20 is subjected to synchronous deformation and the preformed synchronously-deformed structure is consequently formed. In addition, a mark (not shown) caused by such force may be formed on a surface of the preformed synchronously-deformed structure. In some embodiments, the at least one external force is a non-contact force. For example, a suction force generated by a vacuum aspirator or a magnetic attraction force. When the vacuum suction force or the magnetic attraction force is applied to the deformable substrate 20, the deformable substrate 20 is subjected to the synchronous deformation and the preformed synchronously-deformed structure is consequently produced.

In a step S43, the housing 26, the piezoelectric actuator 23 and the deformable substrate 20 are sequentially stacked on each other and coupled with each other. Consequently, a specified depth δ is defined between the movable part 22a of the flexible plate 22 and the piezoelectric actuator 23. In this step, the piezoelectric actuator 23 is covered by the housing 26 (see FIG. 3A). After the piezoelectric actuator 23 is received within the accommodation space 26a of the housing 26, the preformed synchronously-deformed structure of the deformable substrate 20 is assembled with the piezoelectric actuator 23 and collectively received within the accommodation space 26a of the housing 26 to seal the bottom of the piezoelectric actuator 23 and align the movable part 22a of the flexible plate 22 with the vibration plate 230. In accordance with the present invention, the preformed synchronously-deformed structure of the deformable substrate 20 is bent in the direction toward or away the vibration plate 230 so as to define the specified depth δ between the flexible plate 22 and the vibration plate 230. Consequently, the fluid control device 2 with the preformed synchronously-deformed structure is produced.

In the above embodiments, the fluid control device comprises the preformed synchronously-deformed structure. The specified depth δ is defined and maintained between the movable part 22a of the flexible plate 22 and the vibration plate 230 (or the bulge 230c of the vibration plate 230). Due to the specified depth δ, the gap can be retained in an adequate range that is not too large to cause inefficiency of fluid transmission, and not too small to cause the contact interference between the flexible plate 22 and the piezoelectric actuator 23. That is, assembling errors of the fluid control device 2 reduces. Consequently, the efficiency of transferring the fluid is enhanced, and the noise is diminished.

From the above descriptions, the present invention provides a fluid control device. Before the fluid control device is assembled, a preformed synchronous deformation process is implemented to form a preformed synchronously-deformed structure. After the preformed synchronously-deformed structure and the piezoelectric actuator are combined together, the specified depth between the movable part of the flexible plate and the vibration plate (or the bulge of the vibration plate) is defined. The specified depth is sufficient to reduce the contact interference between the flexible plate and the piezoelectric actuator. Consequently, the efficiency of transferring the fluid is enhanced, and the noise is reduced. Since the specified depth is advantageous for increasing the efficiency of transferring the fluid and reducing the noise, the product yield is increased and the quality of the fluid control device is significantly enhanced.

While the invention has been described in terms of what is presently considered to be the most practical and preferred embodiments, it is to be understood that the invention needs not be limited to the disclosed embodiments. On the contrary, it is intended to cover various modifications and similar arrangements included within the scope of the appended claims which are to be accorded with the broadest interpretation so as to encompass all such modifications and similar structures.

## Claims

1. A manufacturing method of a fluid control device (2), the fluid control device (2) comprises a housing (26), a piezoelectric actuator (23) and a deformable substrate (20), wherein the piezoelectric actuator (23) comprises a piezoelectric element (233), an outer frame (231), at least one bracket (232) and a vibration plate (230), and the deformable substrate (20) comprises a flexible plate (22) and a communication plate (21), wherein the communication plate (21) comprises at least one inlet (210), the housing (26) comprises at least one outlet (261), and the flexible plate (22) comprises a movable part (22a) and a central aperture (220), the manufacturing method **characterized in:**
(a) stacking and coupling the flexible plate (22) and the communication plate (21) of the deformable substrate (20), and implementing a preformed synchronous deformation process thereon to form a preformed synchronously-deformed structure defined by the flexible plate (22) and the communication plate (21) collaboratively; and
(b) coupling the housing (26), the piezoelectric actuator (23) and the deformable substrate (20) which are sequentially stacked, wherein the preformed synchronously-deformed structure is aligned with the vibration plate (230) to define a specified depth (δ) between the movable part (22a) of the flexible plate (22) and the vibration plate (230).

2. The manufacturing method according to claim 1, wherein the vibration plate (230) has a first surface (230b) and an opposing second surface (230a), a bulge (230c) is formed on the second surface (230b) of the vibration plate (230), and
the preformed synchronously-deformed structure is aligned with the bulge (230c) of the vibration plate (230) to define the specified depth (δ) between the movable part (22a) of the flexible plate (22) and the bulge (230c) of the vibration plate (230).

3. The manufacturing method according to claim 2, wherein a synchronously-deformed region of the flexible plate (22) for defining the preformed synchronously-deformed structure includes the movable part (22a), the preformed synchronously-deformed structure is a curvy synchronously-deformed structure, and a specified depth (δ) is defined between the curvy synchronously-deformed structure and the bulge (230c) of the vibration plate (230).

4. The manufacturing method according to claim 2, wherein a synchronously-deformed region of the flexible plate (22) for defining the preformed synchronously-deformed structure includes the movable part (22a), the preformed synchronously-deformed structure is a conical synchronously-deformed structure, and a specified depth (δ) is defined between the conical synchronously-deformed structure and the bulge (230c) of the vibration plate (230).

5. The manufacturing method according to claim 2, wherein a synchronously-deformed region of the flexible plate (22) for defining the preformed synchronously-deformed structure includes the movable part (22a) and a region beyond the movable part (22a) of the flexible plate (22), and the specified depth (δ) is defined between the preformed synchronously-deformed structure and the bulge (230c) of the vibration plate (230).

6. The manufacturing method according to claim 2, wherein a synchronously-deformed region of the flexible plate (22) for defining the preformed synchronously-deformed structure includes the movable part (22a) and a region beyond the movable part (22a) of the flexible plate (22), the preformed synchronously-deformed structure is a curvy synchronously-deformed structure, and a specified depth (δ) is defined between the curvy synchronously-deformed structure and the bulge (230c) of the vibration plate (230).

7. The manufacturing method according to claim 2, wherein a synchronously-deformed region of the flexible plate (22) for defining the preformed synchronously-deformed structure includes the movable part (22a) and a region beyond the movable part (22a) of the flexible plate (22), the preformed synchronously-deformed structure is a conical synchronously-deformed structure, and a specified depth (δ) is defined between the conical synchronously-deformed structure and the bulge (230c) of the vibration plate (230).

8. The manufacturing method according to claim 2, wherein the preformed synchronously-deformed structure is a curvy-surface synchronously-deformed structure composed of the communication plate (21) and the flexible plate (22), the curvy-surface synchronously-deformed structure comprises plural curvy surfaces with different curvatures, and a specified depth (δ) is defined between the curvy-surface synchronously-deformed structure and the bulge (230c) of the vibration plate (230).

9. The manufacturing method according to claim 2, wherein the preformed synchronously-deformed structure is a curvy-surface synchronously-deformed structure composed of the communication plate (21) and the flexible plate (22), the curvy-surface synchronously-deformed structure comprises plural curvy surfaces with an identical curvature, and a specified depth (δ) is defined between the curvy-surface synchronously-deformed structure and the bulge (230c) of the vibration plate (230).

10. The manufacturing method according to one of claims 2-9, wherein the preformed synchronously-deformed structure is a bent synchronously-deformed structure that is bent in a direction toward the bulge (230c) of the vibration plate (230), and a specified depth (δ) is defined between the bent synchronously-deformed structure and the bulge (230c) of the vibration plate (230).

11. The manufacturing method according to one of claims 2-9, wherein the preformed synchronously-deformed structure is a bent synchronously-deformed structure that is bent in a direction away from the bulge (230c) of the vibration plate (230), and a specified depth (δ) is defined between the bent synchronously-deformed structure and the bulge (230c) of the vibration plate (230).

12. The manufacturing method according to claim 1, wherein the preformed synchronously-deformed structure is a curvy synchronously-deformed structure composed of the communication plate (21) and the flexible plate (22), and a specified depth (δ) is defined between the curvy synchronously-deformed structure and the vibration plate (230).

13. The manufacturing method according to claim 1, wherein the preformed synchronously-deformed structure is a conical synchronously-deformed structure composed of the communication plate (21) and the flexible plate (22), and a specified depth (δ) is defined between the conical synchronously-deformed structure and the vibration plate (230).

14. The manufacturing method according to claim 1, wherein the preformed synchronously-deformed structure is a curvy-surface synchronously-deformed structure composed of the communication plate (21) and the flexible plate (22), the curvy-surface synchronously-deformed structure comprises plural curvy surfaces with different curvatures, and a specified depth (δ) is defined between the curvy-surface synchronously-deformed structure and the vibration plate (230).

15. The manufacturing method according to claim 1, wherein the preformed synchronously-deformed structure is a curvy-surface synchronously-deformed structure composed of the communication plate (21) and the flexible plate (22), the curvy-surface synchronously-deformed structure comprises plural curvy surfaces with an identical curvature, and a specified depth (δ) is defined between the curvy-surface synchronously-deformed structure and the vibration plate (230).

## Patentansprüche

1. Herstellungsverfahren einer Fluidsteuerungsvorrichtung (2), wobei die Fluidsteuerungsvorrichtung (2) ein Gehäuse (26), ein piezoelektrisches Stellglied (23) und ein verformbares Substrat (20) umfasst, wobei das piezoelektrische Stellglied (23) ein piezoelektrisches Element (233), einen Außenrahmen (231), mindestens eine Halterung (232) und eine Vibrationsplatte (230) umfasst, und das verformbare Substrat (20) eine flexible Platte (22) und eine Verbindungsplatte (21) umfasst, wobei die Verbindungsplatte (21) mindestens einen Einlass (210) umfasst, das Gehäuse (26) mindestens einen Auslass (261) umfasst und die flexible Platte (22) einen beweglichen Teil (22a) und eine zentrale Öffnung (220) umfasst, wobei das Herstellungsverfahren **gekennzeichnet ist durch:**
(a) Stapeln und Verkoppeln der flexiblen Platte (22) und der Verbindungsplatte (21) des verformbaren Substrats (20) und Implementieren eines vorgeformten synchronen Verformungsprozesses darauf, um eine vorgeformte synchron verformte Struktur zu bilden, die **durch** die flexible Platte (22) und die Verbindungsplatte (21) gemeinsam definiert ist; und
(b) Verkoppeln des Gehäuses (26), des piezoelektrischen Aktuators (23) und des verformbaren Substrats (20), die nacheinander gestapelt sind, wobei die vorgeformte synchron verformte Struktur zu der Vibrationsplatte (230) ausgerichtet ist, um eine bestimmte Tiefe (δ) zwischen dem beweglichen Teil (22a) der flexiblen Platte (22) und der Vibrationsplatte (230) zu definieren.

2. Herstellungsverfahren nach Anspruch 1, wobei die Vibrationsplatte (230) eine erste Oberfläche (230b) und eine gegenüberliegende zweite Oberfläche (230a) aufweist, eine Wölbung (230c) auf der zweiten Oberfläche (230b) der Vibrationsplatte (230) ausgebildet ist, und
die vorgeformte synchron verformte Struktur zu der Wölbung (230c) der Vibrationsplatte (230) ausgerichtet ist, um die vorgegebene Tiefe (δ) zwischen dem beweglichen Teil (22a) der flexiblen Platte (22) und der Wölbung (230c) der Vibrationsplatte (230) zu definieren.

3. Herstellungsverfahren nach Anspruch 2, wobei ein synchron verformter Bereich der flexiblen Platte (22) zum Definieren der vorgeformten synchron verformten Struktur den beweglichen Teil (22a) beinhaltet, die vorgeformte synchron verformte Struktur eine kurvig synchron verformte Struktur ist und eine bestimmte Tiefe (δ) zwischen der kurvige synchron verformten Struktur und der Wölbung (230c) der Vibrationsplatte (230) definiert wird.

4. Herstellungsverfahren nach Anspruch 2, wobei ein synchron verformter Bereich der flexiblen Platte (22) zum Definieren der vorgeformten synchron verformten Struktur den beweglichen Teil (22a) beinhaltet, die vorgeformte synchron verformte Struktur eine konisch synchron verformte Struktur ist und eine vorgegebene Tiefe (δ) zwischen der konisch synchron verformten Struktur und der Wölbung (230c) der Vibrationsplatte (230) definiert wird.

5. Herstellungsverfahren nach Anspruch 2, wobei ein synchron verformter Bereich der flexiblen Platte (22) zum Definieren der vorgeformten synchron verformten Struktur den beweglichen Teil (22a) und einen Bereich jenseits des beweglichen Teils (22a) der flexiblen Platte (22) beinhaltet und die vorgegebene Tiefe (δ) zwischen der vorgeformten synchron verformten Struktur und der Wölbung (230c) der Vibrationsplatte (230) definiert wird.

6. Herstellungsverfahren nach Anspruch 2, wobei ein synchron verformter Bereich der flexiblen Platte (22) zum Definieren der vorgeformten synchron verformten Struktur den beweglichen Teil (22a) und einen Bereich jenseits des beweglichen Teils (22a) der flexiblen Platte (22) beinhaltet, die vorgeformte synchron verformte Struktur eine kurvig synchron verformte Struktur ist und eine bestimmte Tiefe (δ) zwischen der kurvenreichen synchron verformten Struktur und der Wölbung (230c) der Vibrationsplatte (230) definiert wird.

7. Herstellungsverfahren nach Anspruch 2, wobei ein synchron verformter Bereich der flexiblen Platte (22) zum Definieren der vorgeformten synchron verformten Struktur den beweglichen Teil (22a) und einen Bereich jenseits des beweglichen Teils (22a) der flexiblen Platte (22) beinhaltet, die vorgeformte synchron verformte Struktur eine konisch synchron verformte Struktur ist und eine bestimmte Tiefe (δ) zwischen der konisch synchron verformten Struktur und der Wölbung (230c) der Vibrationsplatte (230) definiert wird.

8. Herstellungsverfahren nach Anspruch 2, wobei die vorgeformte synchron verformte Struktur eine mit kurviger Oberfläche verformte Struktur ist, die aus der Verbindungsplatte (21) und der flexiblen Platte (22) zusammengesetzt ist, die mit kurviger Oberfläche verformte Struktur mehrere kurvige Oberflächen mit unterschiedlichen Krümmungen umfasst und eine bestimmte Tiefe (δ) zwischen der mit kurviger Oberfläche verformten Struktur und der Wölbung (230c) der Vibrationsplatte (230) definiert wird.

9. Herstellungsverfahren nach Anspruch 2, wobei die vorgeformte synchron verformte Struktur eine mit kurviger Oberfläche verformte Struktur ist, die aus der Verbindungsplatte (21) und der flexiblen Platte (22) zusammengesetzt ist, die mit kurviger Oberfläche verformte Struktur mehrere kurvige Oberflächen mit identischer Krümmung umfasst und eine bestimmte Tiefe (δ) zwischen der mit kurviger Oberfläche verformten Struktur und der Wölbung (230c) der Vibrationsplatte (230) definiert wird.

10. Herstellungsverfahren nach einem der Ansprüche 2-9, wobei die vorgeformte synchron verformte Struktur eine gebogene synchron verformte Struktur ist, die in einer Richtung hin zu der Wölbung (230c) der Vibrationsplatte (230) gebogen ist, und eine bestimmte Tiefe (δ) zwischen der gebogenen synchron verformten Struktur und der Wölbung (230c) der Vibrationsplatte (230) definiert wird.

11. Herstellungsverfahren nach einem der Ansprüche 2-9, wobei die vorgeformte synchron verformte Struktur eine gebogene synchron verformte Struktur ist, die in einer Richtung weg von der Wölbung (230c) der Vibrationsplatte (230) gebogen wird, und eine bestimmte Tiefe (δ) zwischen der gebogenen synchron verformten Struktur und der Wölbung (230c) der Vibrationsplatte (230) definiert wird.

12. Herstellungsverfahren nach Anspruch 1, wobei die vorgeformte synchron verformte Struktur eine kurvige synchron verformte Struktur ist, die aus der Verbindungsplatte (21) und der flexiblen Platte (22) zusammengesetzt ist, und eine bestimmte Tiefe (δ) zwischen der kurvig synchron verformten Struktur und der Vibrationsplatte (230) definiert wird.

13. Herstellungsverfahren nach Anspruch 1, wobei die vorgeformte synchron verformte Struktur eine konisch synchron verformte Struktur ist, die aus der Verbindungsplatte (21) und der flexiblen Platte (22) zusammengesetzt ist, und eine vorgegebene Tiefe (δ) zwischen der konisch synchron verformten Struktur und der Vibrationsplatte (230) definiert wird.

14. Herstellungsverfahren nach Anspruch 1, wobei die vorgeformte synchron verformte Struktur eine mit kurviger Oberfläche synchron verformte Struktur ist, die aus der Verbindungsplatte (21) und der flexiblen Platte (22) zusammengesetzt ist, die mit kurviger Oberfläche synchron verformte Struktur mehrere kurvige Oberflächen mit unterschiedlichen Krümmungen umfasst und eine bestimmte Tiefe (δ) zwischen der mit kurviger Oberfläche synchron verformten Struktur und der Vibrationsplatte (230) definiert wird.

15. Herstellungsverfahren nach Anspruch 1, wobei die vorgeformte synchron verformte Struktur eine mit kurviger Oberfläche synchron verformte Struktur ist, die aus der Verbindungsplatte (21) und der flexiblen Platte (22) zusammengesetzt ist, die mit kurviger Oberfläche synchron verformte Struktur mehrere kurvige Oberflächen mit einer identischen Krümmung umfasst und eine vorgegebene Tiefe (δ) zwischen der mit kurviger Oberfläche synchron verformten Struktur und der Vibrationsplatte (230) definiert wird.

## Revendications

1. Un procédé de fabrication d'un dispositif de régulation de fluide (2), le dispositif de régulation de fluide comprenant un boîtier (26), un actionneur piézoélectrique (23) et un substrat déformable (20), dans lequel l'actionneur piézoélectrique (23) comprend un élément piézoélectrique (233), un cadre extérieur (231), au moins un support (232) et une plaque vibrante (230), et le substrat déformable (20) comprenant une plaque flexible (22) et une plaque de communication (21), dans lequel la plaque de communication (21) comporte au moins une entrée (210), le boîtier (26) comprenant au moins une évacuation (261), et la plaque flexible (22) comprenant une partie mobile (22a) et une ouverture centrale (220), le procédé de fabrication **étant caractérisé par** :
(a) l'empilement et le couplage de la plaque flexible (22) et de la plaque de communication (21) du substrat déformable (20), et la mise en oeuvre d'un processus de déformation synchrone préformé pour former une structure préformée déformée de manière synchrone définie de manière collaborative par la plaque flexible (22) et par la plaque de communication (21); et
(b) le coupage du boîtier (26), de l'actionneur piézoélectrique (23) et du substrat déformable (20) qui sont empilés séquentiellement, dans lequel la structure préformée déformée de manière synchrone est alignée avec la plaque de vibration (230) pour définir une profondeur spécifiée (δ) entre la partie mobile (22a) de la plaque flexible (22) et la plaque vibrante (230).

2. Le procédé de fabrication selon la revendication 1, dans lequel la plaque de vibration (230) a une première surface (230b) et une seconde surface opposée (230a), un renflement (230c) étant formée sur la seconde surface (230b) de la plaque de vibration (230), et
la structure préformée déformée de manière synchrone est alignée avec le renflement (230c) de la plaque de vibration (230) pour définir la profondeur spécifiée (δ) entre la partie mobile (22a) de la plaque flexible (22) et la plaque vibrante (230).

3. Le procédé de fabrication selon la revendication 2, dans lequel une région déformée de manière synchrone de la plaque flexible (22) pour définir la structure préformée déformée de manière synchrone comprend la partie mobile (22a), la structure préformée déformée de manière synchrone étant une structure conique déformée de manière synchrone et une profondeur spécifiée (δ) est définie entre la structure conique déformée de manière synchrone et le renflement (230c) de la plaque vibrante (230).

4. Le procédé de fabrication selon la revendication 2, dans lequel une région déformée de manière synchrone de la plaque flexible (22) pour définir la structure préformée déformée de manière synchrone comprend la partie mobile (22a), la structure préformée déformée de manière synchrone étant une structure conique déformée de manière synchrone, et une profondeur spécifiée (δ) est définie entre la structure conique déformée de manière synchrone et le renflement (230c) de la plaque vibrante (230).

5. Le procédé de fabrication selon la revendication 2, dans lequel une région déformée de manière synchrone de la plaque flexible (22) pour définir la structure préformée déformée de manière synchrone comprend la partie mobile (22a), et une région au-delà de la partie mobile (22a) de la plaque flexible (22), et la profondeur spécifiée (δ) est définie entre la structure préformée déformée de manière et le renflement (230c) de la plaque vibrante (230).

6. Le procédé de fabrication selon la revendication 2, dans lequel une région déformée de manière synchrone de la plaque flexible (22) pour définir la structure préformée déformée de manière synchrone comprend la partie mobile (22a) et une région au-delà de la partie mobile (22a) de la plaque flexible (22), la structure préformée de manière synchrone est une structure conique déformée de manière synchrone et une profondeur spécifiée (δ) est définie entre la structure conique à déformation synchrone et le renflement (230c) de la plaque vibrante (230).

7. Le procédé de fabrication selon la revendication 2, dans lequel une région déformée de manière synchrone de la plaque flexible (22) pour définir la structure préformée déformée de manière synchrone comprend la partie mobile (22a) et une région au-delà de la partie mobile (22a) de la plaque flexible (22), la structure préformée déformée de manière synchrone est une structure conique déformée de manière synchrone, et une profondeur spécifiée (δ) est définie entre la structure conique déformée de manière synchrone et le renflement (230c) de la plaque vibrante (230).

8. Le procédé de fabrication selon la revendication 2, dans lequel la structure préformée déformée de manière synchrone est une structure à surface courbe déformée de manière synchrone composée de la plaque de communication (21) et de la plaque flexible (22), la structure à surface courbe déformée de manière synchrone comprend plusieurs surfaces courbes ayant différentes courbures, et une profondeur spécifiée (δ) est définie entre la structure à surface incurvée déformée de manière synchrone et le renflement (230c) de la plaque vibrante (230).

9. Le procédé de fabrication selon la revendication 2, dans lequel la structure préformée déformée de manière synchrone est une structure à surface incurvée déformée de manière synchrone de la plaque de communication (21) et de la plaque flexible (22), la structure à surface incurvée déformée de manière synchrone comporte plusieurs surfaces courbes ayant une courbure identique, et une profondeur spécifiée (δ) est définie entre la structure à surface incurvée déformée de manière synchrone et le renflement (230c) de la plaque vibrante (230).

10. Le procédé de fabrication selon l'une des revendications 2-9, dans lequel la structure préformée déformée de manière synchrone est une structure courbe déformée de manière synchrone qui est courbée dans une direction vers le renflement (230c) de la plaque vibrante (230), et une profondeur spécifiée (δ) est définie entre la structure courbe déformée de manière synchrone et le renflement (230c) de la plaque vibrante (230).

11. Le procédé de fabrication selon l'une des revendications 2-9, dans lequel la structure préformée déformée de manière synchrone est une structure courbe déformée de manière synchrone qui est courbée dans une direction s'éloignant du renflement (230c) de la plaque vibrante (230), et une profondeur spécifiée (δ) est définie entre la structure courbe déformée de manière synchrone et le renflement (230c) de la plaque vibrante (230).

12. Le procédé de fabrication selon la revendication 1, dans lequel la structure préformée déformée de manière synchrone est une structure incurvée déformée de manière synchrone composée de la plaque de communication (21) et de la plaque flexible (22), et une profondeur spécifiée (δ) est définie entre la structure incurvée déformée de manière synchrone et la plaque vibrante (230).

13. Le procédé de fabrication selon la revendication 1, dans lequel la structure préformée déformée de manière synchrone est une structure conique déformée de manière synchrone composée de la plaque de communication (21) et de la plaque flexible (22), et une profondeur spécifiée (δ) est définie entre structure conique déformée de manière synchrone et la plaque vibrante (230).

14. Le procédé de fabrication selon la revendication 1, dans lequel la structure préformée déformée de manière synchrone est une structure à surface courbe à déformée de manière synchrone composée de la plaque de communication (21) et de la plaque flexible (22), la structure à surface courbe déformée de manière synchrone comprend plusieurs surfaces courbes avec différentes courbures, et une profondeur spécifiée (δ) est définie entre la structure à surface courbe déformée de manière synchrone et la plaque vibrante (230).

15. Le procédé de fabrication selon la revendication 1, dans lequel la structure préformée déformée de manière synchrone est une structure à surface courbe déformée de manière synchrone composée de la plaque de communication (21) et de la plaque flexible (22), la structure à surface courbe déformée de manière synchrone comprenant plusieurs surfaces courbes ayant une courbure identique, et une profondeur spécifiée (δ) est définie entre la structure à surface courbe déformée de manière synchrone et la plaque vibrante (230).
